Europäisches Patentamt

European Patent Office

Office européen des brevets

(11) Publication number: **0 268 260 B1**

(12) **EUROPEAN PATENT SPECIFICATION**

(45) Date of publication of patent specification: **05.08.92**  (51) Int. Cl.⁵: **H01L 23/58**, H01L 23/52, H01L 23/36

(21) Application number: **87116952.0**

(22) Date of filing: **17.11.87**

(54) **Flexible film chip carrier with decoupling capacitors.**

(30) Priority: **18.11.86 US 931813**

(43) Date of publication of application:
**25.05.88 Bulletin 88/21**

(45) Publication of the grant of the patent:
**05.08.92 Bulletin 92/32**

(84) Designated Contracting States:
**DE FR GB IT**

(56) References cited:
**EP-A- 0 071 311**
**EP-A- 0 072 759**
**EP-A- 0 137 385**
**EP-A- 0 178 227**

**PATENT ABSTRACTS OF JAPAN, vol. 10, no. 184 (E-415)[2240], 27th June 1986; & JP-A-61 30 067**

**IBM TECHNICAL DISLOSURE BULLETIN, vol. 27, no. 10A, March 1985, page 5646, New York, US; "Circuit module with bottom-mounted decoupling capacitors"**

(73) Proprietor: **International Business Machines Corporation**
**Old Orchard Road**
**Armonk, N.Y. 10504(US)**

(72) Inventor: **Black, Vincent Joseph**
**35 Crescent Drive**
**Apalachin, N.Y. 13732(US)**
Inventor: **Charsky, Ronald Stephen**
**24 Oveebrook Avenue**
**Binghamton, N.Y. 13903(US)**
Inventor: **Olson, Leonard Theodore**
**2628 Laguna Drive, RD 3**
**Endwell, N.Y. 13760(US)**

(74) Representative: **Klein, Daniel Jacques Henri**
**Compagnie IBM France Département de Propriété Intellectuelle**
**F-06610 La Gaude(FR)**

EP 0 268 260 B1

## Description

### Background of the Invention

#### 1. Field of the Invention

This invention relates to integrated circuit semiconductor chip packages and more particularly to semiconductor chip carrier, first level electronic packages having high frequency decoupling capacitors as a part of the package.

#### 2. Background Information

As very large scale integrated (LSI) circuits tend to get more complex, there is a need to switch more output driver circuits at a faster rate in order to increase the performance thereof. Moreover, an increase in the use of parallel processing techniques have necessitated designing semiconductor chip carriers for optimum performance of the LSI circuits. Similarly, these techniques require a high number of driver circuits to switch simultaneously at fast transition speeds and high currents. The effective inductance of semiconductor chip and package power paths for these active switching circuits relates directly to the amount of power distribution noise. Power paths which feed the driver circuits are particularly noise sensitive to the inherent effective inductance for simultaneous switching activity. Various techniques have been utilized in the art to minimize the level of switching noise associated with the increase and the magnitude of the switching rate.

One known technique for reducing the level of noise is to incorporate discrete capacitors as a decoupling capacitor between associated voltage pins. Generally, the discrete capacitors, which are mounted on a top surface of a carrier and distance away from the semiconductor chip, are electrically coupled thereto by a plurality of power wiring lines or a large power bus. This technique of positioning the discrete capacitors on the top surface of a carrier reduces the wire-ability on the top surface. Moreover, the power wiring lines typically represent long inductance paths which, in response to the increase in current flowing therein, facilitate the development of voltage drops thereacross. The voltage drops are viewed as unwanted power distribution noise. One technique of minimizing the inductances paths is move the discrete capacitors as close to the semiconductor chip as possible. However, in view of either the layout of the wiring lines on the top surface associated with the semiconductor chip or the physical dimensions of the discrete capacitor, this technique does not result in a substantial reduction in the inductance paths and the noise associated therewith.

In Ref. D1, patent abstracts of Japan Vol. 10 n° 184 (4-145) (2240), 27.06.1986, JP-A-6130067, there is disclosed an hybrid module offering the combination of a plurality of S/C chips and passive components, e.g a capacitor, wherein the S/C chips and the passive components are mounted on opposite sides of an insulating substrate mounted on a lead frame. Consequentially, there is a need for a technique which reduces the noise associated with the increase in the rate which the current switches, minimizes the inductances paths and maximizes the wireability of the top surface of the carrier associated with the semiconductor chip.

### Objects of the Invention

Therefore it is an object of the invention to provide an improved electronic package for semiconductor chips.

It is another object of the invention to provide a technique for connecting decoupling capacitors directly to the semiconductor chips input/output lines.

It is still another object of the invention to increase the wireability of a carrier associated with the semiconductor chip.

### Summary of the Invention

In accordance with these objects, features and advantages of the invention are accomplished by an electronic packaging structure as described in claim 1.

### Brief Description of the Drawings

The foregoing and other advantages of the invention will be more fully understood with reference to the description of the best mode and the drawings wherein:

Fig.1 shows a side view of an electronic package in accordance with the principles of this invention;

Fig. 2 shows a exploded sectional view of a semiconductor chip mounted on a flexible carrier having a discrete capacitor coupled thereto in accordance with the principles of this invention; and

Fig. 3 shows an alternate embodiment of the electronic package of Fig. 1 in accordance with the principles of this invention.

### Description of the Best Mode for Carrying out the Invention

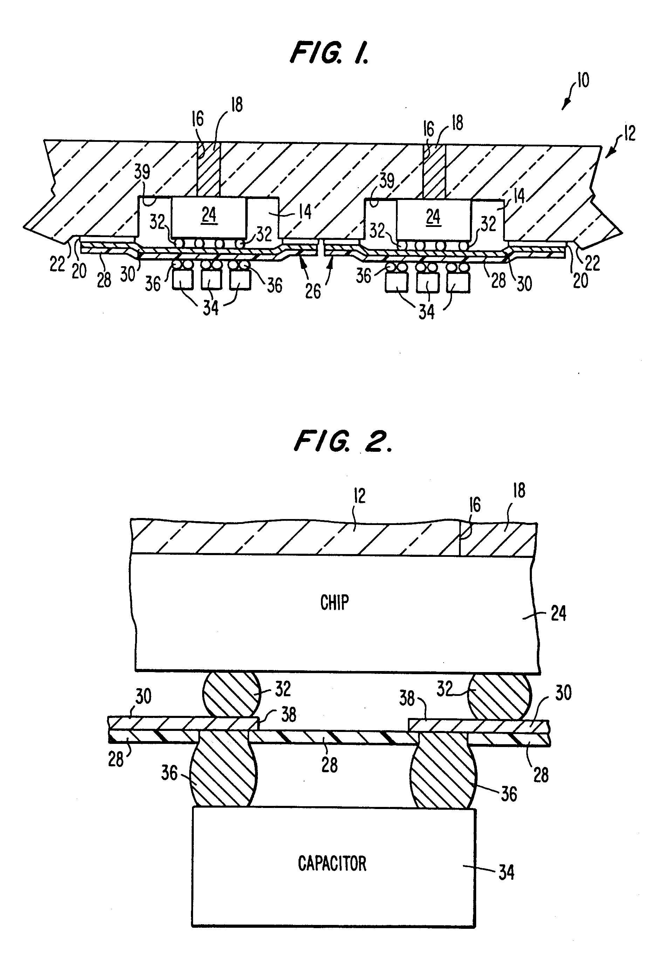

Referring to Fig. 1, there is shown a side view of an electronic package 10. The package 10 includes a ceramic card 12 having a plurality of cavities 14 formed therein. The plurality of apertures 16 are formed through the ceramic card 12 so that a selected one of the apertures communicates with a selected one of the cavities 14. A metal stub 18, which is positioned within each one of the plurality of apertures 16, facilitates the conductance of heat away from the respective one of the cavities 14. A plurality of wiring lines 20, formed on a first surface 22 of the ceramic card 12, serve as signal and power lines.

Fig. 2 shows an exploded sectional view of the electronic package 10. Referring to Figs. 1 and 2, at least one semiconductor chip 24 is mounted on a first major surface of a thin-film structure such as a flexible film carrier film 26. The flexible film carrier 26 includes a layer of polyimide film 28 and a layer of metal 30 formed on a first major surface of the polyimide layer. The layer of metal 30 is processed to form a plurality of signal and power lines. Input/output contacts associated with the semiconductor chip 24 are coupled to selected ones of the signal and power lines by a plurality of solder bonds 32. A plurality of discrete capacitors 34 are mounted on a second major surface of the flexible film carrier 26. The capacitors 34 are coupled to selected ones of the input/out contacts of the semiconductor chip 24 by a plurality of solder bonds 36 and vias 38 formed in the polyimide film 28. Moreover, the discrete capacitors are mounted such that a first terminal of a selected one of the capacitors is connected to a first potential and a second terminal of the capacitor is connected to a second potential.

The flexible film carrier 26 is then mounted on the ceramic card 12 so that (1) the signal and power lines formed on the flexible carrier are coupled to the wiring lines 20 formed on the ceramic card in order to interconnect the input/output contacts to the ceramic card and (2) the semiconductor chip 24 is positioned within a selected one of the cavities 14 and communicates with the stub 18. The semiconductor chip 24 may be adhesively secured to an upper wall 39 of the selected one of the cavities 14. Moreover, a heat sink (not shown) may be coupled to the metal stubs 18 to facilitate the conductions of heat from the respective semiconductive chip 24.

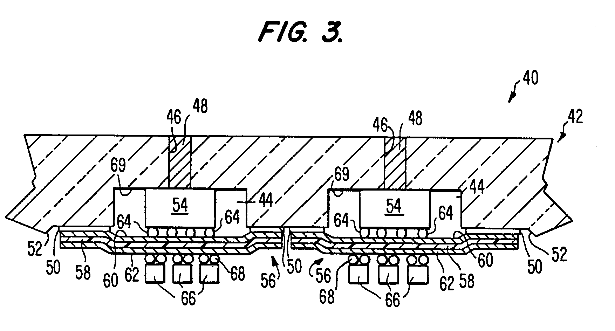

Referring to Fig. 3, there is shown a side view of an alternate embodiment of an electronic package 40. The package 40 includes a ceramic card 42 having a plurality of cavities 44 formed therein. A plurality of apertures 46 are formed through the ceramic card 42 so that a selected one of the apertures communicates with a selected one of the cavities 44. A metal stub 48, which is positioned within each one of the plurality of apertures 46, facilitates the conduction of heat away from the respective one of the cavities 44. A plurality of wiring lines 50, formed on a first surface 52 of the ceramic card 42, serve as signal and power lines.

At least one semiconductor chip 54 is mounted on a first surface of a thin-film structure such as a flexible film carrier 56. The flexible film carrier 56 includes a layer of polyimide film 58, a first layer of metal 60 formed on a first major surface of the polyimide layer and a second layer of metal 62 formed on a second major surface of the polyimide layer. The first layer of metal 60 is processed to form a plurality of signal lines. The second layer of metal 62 is processed to form a power/ground plane which also serves as a reference plane for the signal lines formed in the first layer of metal 60. Input/output contacts associated with the semiconductor chip 54 are coupled to selected ones of the signal lines by a plurality of solder bonds 64. The plurality of discrete capacitors 66 are mounted on and electrically coupled to the second layer of metal 62 by a plurality of solder bonds 68 so that a first terminal of a selected capacitor is coupled to a first potential while a second terminal of the capacitor is connected to a second potential. Additionally, the discrete capacitors 66 are coupled to selected ones of the input/output contacts of the semiconductor chip 64 through vias formed in the polyimide layer 58 and the first layer of metal 60. The input/output contacts are also coupled to the power/ground plane in a similar manner to provide power and ground signals to the semiconductor chip 54.

The flexible film carrier 56 is then mounted on the ceramic card 42 so that (1) the signal lines formed in the first layer of metal 60 of the flexible carrier are coupled to the wiring lines 50 formed on the ceramic card in order to interconnect the input/output contacts to the ceramic card and (2) one semiconductor chip 54 is positioned within a selected one of the cavities 44 and communicates with the selected one of the stubs 48. The semiconductor chip 54 may be adhesively secured to an upper wall 69 of the selected one of the cavities 44. Additionally, a heat sink (not shown) may be coupled to the metal stubs 48 to facilitate the conductance of heat away from the respective semiconductor chip 54.

In summary, the flexible film carriers 26 and 56 includes at least one semiconductor chip 24 and 54, respectively, mounted on one side thereof and decoupling capacitors 34 and 66 mounted on an opposite side thereof, respectively. The flexible carriers 26 and 56 are then mounted on respective ceramic cards 12 and 42 so that (1) one semiconductor chip 24 and 54 is positioned with each of the plurality of cavities 14 and 44, respectively and (2) signal and power lines formed on the flexible carrier are coupled to wiring lines 20 and 50, respectively, formed on the ceramic card 12 and 14. Mounting the decoupling capacitors 34 and 66 in this manner places the capacitors extremely close to input/output contacts associated with the respective semiconductor chip 24 and 56 which minimizes the inductance paths and reduces electrical switching noise caused by a plurality of off-chip drivers (OCDs). Moreover, this reduction in the electrical switching noise facilitates an increase in the number of OCDs which may be switched simultaneously at relatively fast transition rates and high currents.

## Claims

1. An electronic packaging structure comprising:
a ceramic card (12) having at least one cavity (14) therein for accommodating a semiconductor chip and having circuitry (20) for electrical connection to the said semiconductor chip; and
a thin circuitized film structure (26) consisting of a polyimide film chip carrier (28) provided with vias (38) supporting at least one metal pattern (30) on one side;
at least one semiconductor chip (24) mounted on said one side of the film structure, the input/output contacts (32) of said chip being electrically connected to said metal pattern (30);
at least one decoupling capacitor (34) mounted on the opposite side of the film structure and electrically connected to the input/output contacts (32) of said semiconductor chip (24) through said vias (38); said film structure being mounted on said ceramic card with the semiconductor chip positioned in said cavity and with the metal pattern (30) of said film structure (26) connected to the circuitry (20) of said ceramic card.

2. The electronic packaging structure as recited in claim 1 further including means for cooling this semiconductor chip.

3. The electronic packaging structure as recited in claim 2 wherein the cooling means includes:
an aperture (16) formed through said ceramic card which communicates with the cavity thereof; and
a metal stub (18) inserted into the aperture in contact with the semiconductor chip (24) for transferring heat away therefrom.

4. The electronic packaging structure as recited in one of the claims 1-3 wherein
the thin circuitized film structure is flexible and has a plurality of signal lines formed on a first surface and a power/ground plane formed on a second surface, and
wherein the decoupling capacitor is mounted on the power/ground plane and electrically coupled to selected input/output contacts of the semiconductor chip.

## Revendications

1. Structure de groupage électronique comprenant :
une carte céramique (12) comportant au moins une cavité (14) pour recevoir une puce semiconductrice et comportant un circuit (20) pour la connexion électrique à ladite puce semiconductrice ; et
une structure à couche mince portant un circuit (26), constituée d'un support de puce en film de polyimide (28) pourvu de traversées (38) et supportant au moins une configuration de métal (30) sur une première face ;
au moins une puce semiconductrice (24) montée sur ladite première face de la structure de film, les contacts d'entrée/sortie (32) de ladite puce étant électriquement connectés à ladite configuration de métal (30) ;
au moins un condensateur de découplage (34) monté sur la face opposée de la structure de film et électriquement connecté aux contacts d'entrée/sortie (32) de ladite puce semiconductrice (24) par l'intermédiaire des dites traversées (38) ;
ladite structure de film étant montée sur ladite carte céramique de sorte que la puce semiconductrice se trouve dans ladite cavité et que la configuration de métal (30) de ladite structure de film (26) est connectée au circuit (20) de ladite carte céramique.

2. Structure de groupage électronique suivant la revendication 1, comprenant en outre des moyens pour le refroidissement de cette puce semiconductrice.

3. Structure de groupage électronique suivant la revendication 2, dans laquelle les moyens de refroidissement comprennent :
une ouverture (16) formée à travers ladite carte céramique et qui communique avec sa cavité ; et
une tige métallique (18) insérée dans l'ouverture et en contact avec la puce semiconductrice (24) pour évacuer la chaleur de cette dernière.

4. Structure de groupage électronique suivant une des revendications 1 à 3, dans laquelle
la structure à couche mince portant un circuit est flexible et comporte une pluralité de lignes de signal, formées sur une première surface, et un plan d'alimentation/terre formé sur une deuxième surface, et dans laquelle

le condensateur de découplage est monté sur le plan d'alimentation/terre et électriquement couplé à des contacts d'entrée/sortie choisis de la puce semiconductrice.

bei welchem der Entkopplungskondensator an der Versorgung/Masse-Ebene aufgebracht ist und mit ausgewählten Eingang/Ausgang-Kontakten des Halbleiterchips elektrisch verbunden ist.

**Patentansprüche**

1. Elektronikgehäuseaufbau, der folgendes aufweist:
eine Keramikkarte (12) mit zumindest einem Hohlraum (14) in derselben, um einen Halbleiterchip aufzunehmen, und mit einer Schaltung (20) für eine elektrische Verbindung mit dem Halbleiterchip und
eine dünne, mit Schaltungen versehen Schichtstruktur (26), die aus einem Polyimidschicht-Chipträger (28) besteht, der mit Durchgängen (38) versehen ist, die zumindest ein Metallmuster (30) auf einer Seite tragen,
zumindest einen Halbleiterchip (24), der auf der einen Seite der Schichtstruktur aufgebracht ist, wobei die Eingang/Ausgang-Kontakte (32) des Chips mit dem Metallmuster (30) elektrisch verbunden sind,
zumindest einen Entkopplungskondensator (34), der auf der gegenüberliegenden Seite der Schichtstruktur aufgebracht ist und mit den Eingang/Ausgang-Kontakten (32) des Halbleiterchips (24) über die Durchgänge (38) elektrisch verbunden ist, wobei die Schichtstruktur auf der Keramikkarte so aufgebracht ist, daß der Halbleiterchip in dem Hohlraum angeordnet ist und das Metallmuster (30) der Schichtstruktur (26) mit der Schaltung (20) der Keramikkarte verbunden ist.

2. Elektronikgehäuseaufbau nach Anspruch 1, der ferner ein Mittel zum Kühlen dieses Halbleiterchips aufweist.

3. Elektronikgehäuseaufbau nach Anspruch 2, bei welchem das Kühlmittel folgendes aufweist:
eine Öffnung (16), die durch die Keramikkarte ausgebildet ist, die mit dem Hohlraum derselben komuniziert und
einen Metallstumpf (18), der in Kontakt mit dem Halbleiterchip (24) in die Öffnung eingesetzt ist, um Wärme aus demselben fortzuleiten.

4. Elektronikgehäuseaufbau nach einem der Ansprüche 1 bis 3, bei welchem die dünne, mit Schaltungen versehene Schichtstruktur flexibel ist und eine Mehrzahl von an einer ersten Oberfläche ausgebildeten Signalleitungen und eine an einer zweiten Oberfläche ausgebildete Versorgung/Masse-Ebene aufweist und

## *FIG. I.*

## *FIG. 2.*

*FIG. 3.*